Europäisches Patentamt

European Patent Office

Office européen des brevets

(19)

(11) Numéro de publication : **0 380 168 B1**

(12)                    **FASCICULE DE BREVET EUROPEEN**

(45) Date de publication du fascicule du brevet :
26.04.95 Bulletin 95/17

(51) Int. Cl.[6] : **H03K 19/21,** H03B 19/14,
H01L 27/20

(21) Numéro de dépôt : 90200131.2

(22) Date de dépôt : 18.01.90

(54) "Dispositif semiconducteur intégré incluant un transistor à effet de champ à grille isolée et polarisée en continu à un niveau élevé".

(30) Priorité : 24.01.89 FR 8900809
24.01.89 FR 8900810

(43) Date de publication de la demande :
01.08.90 Bulletin 90/31

(45) Mention de la délivrance du brevet :
26.04.95 Bulletin 95/17

(84) Etats contractants désignés :
DE FR GB IT

(56) Documents cités :
INTERNATIONAL ELECTRON DEVICES MEE-
TING, Washington, DC, 1-4 decembre
1985,Technical Digest, pages 317-320, IEEE,
New York, US; N.C. CIRILLO et
al.:"Complementary heterostructure insulated gate field effect transistors(HIGFETs)"
JAPANESE JOURNAL OF APPLIED PHYSICS,
vol. 24, no. 11, novembre 1985, pages L853-
L854, Japan Society of Physics, Tokyo, JP; N.
YOKOYAMA et al.: "A new functional, reso-
nant-tunneling hot electron transistor (RHET)
ELECTRONICS LETTERS, vol. 23, no. 21, 8
octobre 1987, pages 1127,1128, Hitchin,GB; M.
WOLNY et al.: "High-performance WN-gate
MISFETs fabricated from MOVPE wafers"
IEEE ELECTRON DEVICE LETTERS, vol.
EDL-7, no. 2, fevrier 1986, pages 78-80,IEEE,
New York, US; M.S. SHUR et al.: "New negative resistance regime of heterostructure insulated gate transistor (HIGFET) operation"

(56) Documents cités :
IBM TECHNICAL DISCLOSURE BULLETIN,
vol. 7, no. 4, septembre 1964, page 337,
NewYork, US; W.B. PENNEBAKER:
"Frequency doubler"

(73) Titulaire : **LABORATOIRES D'ELECTRONIQUE
PHILIPS**
**3, Avenue Descartes**
**F-94450 Limeil-Brévannes (FR)**
(84) **FR**
Titulaire : **Philips Electronics N.V.**
**Groenewoudseweg 1**
**NL-5621 BA Eindhoven (NL)**
(84) **DE GB IT**

(72) Inventeur : **Delhaye, Etienne, Société Civile
SPID**
**209 rue l'Université**
**F-75007 Paris (FR)**
Inventeur : **Wolny, Michel, Société Civile SPID**
**209 rue l'Université**
**F-75007 Paris (FR)**
Inventeur : **Aguila, Thierry, Société Civile SPID**
**209 rue l'Université**
**F-75007 Paris (FR)**
Inventeur : **Pyndiah, Ramesh, Société Civile
SPID**
**209 rue l'Université**
**F-75007 Paris (FR)**

(74) Mandataire : **Landousy, Christian et al
Société Civile S.P.I.D.
156, Boulevard Haussmann
F-75008 Paris (FR)**

## Description

L'invention concerne un dispositif semiconducteur intégré, incluant un transistor à effet de champ, d'un type dit à grille isolée, ce transistor étant muni de moyens de polarisation pour obtenir que sa grille soit polarisée en continu à un niveau élevé, de manière à ce que le régime de fonctionnement de ce transistor se situe dans une région où sa caractéristique de courant drain-source en fonction de la tension grille-source montre un maximum de part et d'autre duquel les pentes de la caractéristique sont sensiblement symétriques, en sorte qu'à deux valeurs de la tension grille-source symétriques par rapport à ce maximum correspond sensiblement une même valeur du courant drain-source.

L'invention trouve son application dans la réalisation de circuits numériques ou analogiques.

Les propriétés d'un transistor à effet de chmap, du type dit à grille isolée (HIGFET) sont déjà connues de la publication International Electron Devices Meeting WASHINGTON, DC 1-4 Dec. 1985, Technical Digest pp.317-320, IEEE New-York USA.

Ce document décrit un transistor à effet de champ à grille isolée, cette grille étant elle-même constituée d'une couche de GaAs non dopée. Des performances relatives à ce transistor sont reportées pour des mesures faites à 77 K et 300 K. D'une manière générale, il est divulgué que ce transistor montre une transconductance élevée, mais moins élevée à 300 K (température ambiante) qu'à 77 K.

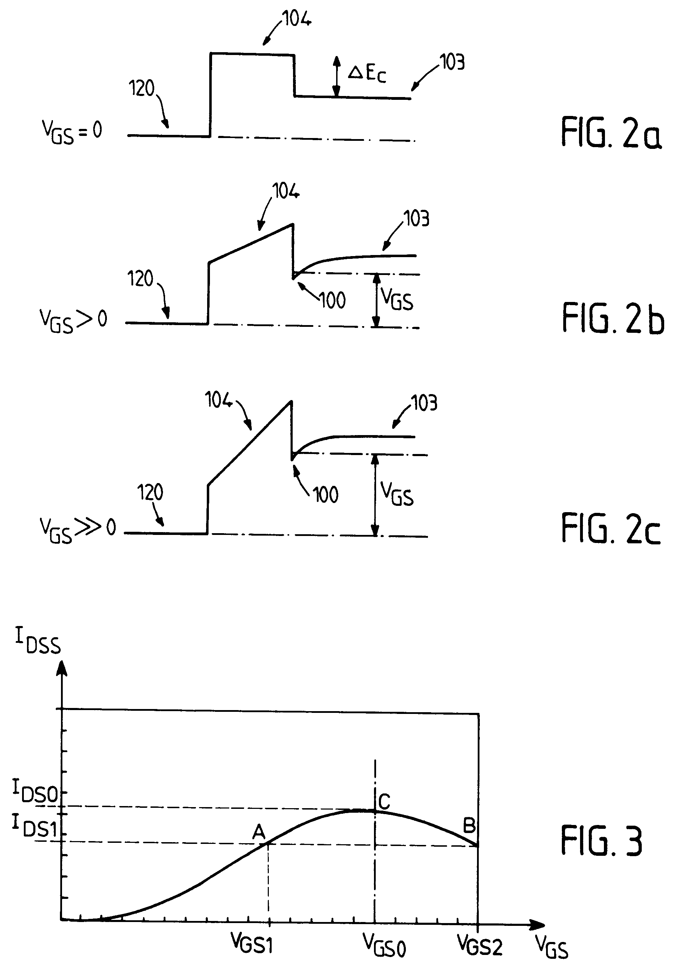

La FIG.3 du document cité montre en particulier la courbe de courant de drain $I_{DS}$ en fonction de la tension grille-source $V_{GS}$ pour la température 77 K. Cette courbe montre un maximum dont les flancs sont sensiblement symétriques. Un phénomène de même nature apparaît pour les transistors N et les trransistors P à 77 K.

Les propriétés d'un transistor à effet de champ à grille isolée sont encore connues par exemple de la publication intitulée "New Negative Resistance Regime of Heterostructure Insulated Gate Transistor Operation" par Michaël F.SHUR and alii, dans "IEEE Electron Device Letters, Vol.EDL-7, N°2, February 1986".

Ce document décrit l'effet de résistance différentielle négative de drain qui apparaît dans un transistor à effet de champ présentant un canal de type de conduction N avec une hétérostructure GaAs-GaAlAs et une grille isolée, à polarisation de grille élevée et constante.

La structure de ce transistor dit HIGFET comprend une couche de GaAs non-intentionnellement dopée, d'épaisseur 0,5 µm, réalisée sur un substrat de GaAs semi-isolant, suivi d'une couche de GaAlAs non-intentionnellement dopée, comme couche d'isolation de grille, sur laquelle un contact de grille en WSi est réalisé. Des régions de source et drain sont délimitées de part et d'autre de la grille par implantation localisée d'ions Si pour les régions N, ou Mg pour les régions P. Les contact ohmiques sur ces régions, lorsqu'elles sont de type N, sont formés par des métallisations de Au-Ge-Ni. Le dispositif est isolé par implantation de protons. La grille présente une longueur de 1,3 µm et une largeur de 10 µm.

Avec ce dispositif, pour une tension grille-source fixe de valeur élevée, environ 3V, une décroissance du courant drain-source apparaît lorsque la tension drain-source varie de 0,8 à 1,25 V. Puis, pour la même tension grille-source fixe, lorsque la tension drain-source varie de 1,25 V à des valeurs supérieures, le courant drain-source augmente. Ces variations du courant drain-source en fonction de la tension drain-source, à tension grille-source constante et élevée conduisent donc à l'observation d'une résistance négative de drain en régime de saturation. Cet effet est dû à un transfert spatial des porteurs du canal collectés par la grille.

Ce document ne décrit d'une part aucune application de l'effet de résistance négative de drain, et en outre ne révèle pas qu'il peut exister aussi, en utilisant un tel transistor dans certaines conditions de polarisation précises, d'autres effets intéressants, et notamment un effet de transconductance négative. A plus forte raison n'est-il pas fait mention d'applications de ce dernier effet.

Il est par ailleurs connu des applications d'un transistor bipolaire à puits quantique, dit transistor à électrons chauds résonants.

Ces applications d'un tel transistor sont par exemple connues de la publication intitulée "A New Functional Resonant-Tunneling Hot Electron Transistor" par NAOKI YOKOYAMA and alii dans "Japanese Journal of Applied Physics, Vol.24, N°11, November 1985, pp.L853 et L854".

La demande de brevet EP 0225 698 concerne exactement le même sujet.

Dans l'une ou l'autre de ces publications, on décrit d'abord un transistor bipolaire à puits quantique disposé entre la base et l'émetteur. Ce transistor dit à électrons chauds résonants est formé d'une couche collecteur, d'une couche barrière de collecteur, d'une couche de base, avec un contact de base, et d'une partie consacrée à former un puits quantique comprenant une alternance de couches de GaAlAs/GaAs, chacune d'une épaisseur de l'ordre de 50 angströms (5 nm), d'une couche d'émetteur et d'un contact d'émetteur. Le contact de collecteur est pris sur la face arrière de la couche de collecteur.

Le puits quantique disposé entre la base et l'émetteur possède des niveaux d'énergie discrets des porteurs. En modifiant la polarisation émetteur-base, on peut égaliser l'énergie des niveaux du puits avec celle du bas de la bande de conduction du matériau de l'émetteur. Par cette méthode, la caractéristique du courant en fonction de la tension de la jonction base-émetteur présente un pic suivi d'une discontinuité.

Les publications citées enseignent que l'on peut réaliser, au moyen d'un tel transistor, soit un circuit non-ou exclusif, soit un circuit multiplieur de fréquence.

Mais le type de transistor utilisé pour réaliser ces circuits présente de nombreux inconvénients dont entre autres :

- tout d'abord, il est extrêmement difficile à mettre en oeuvre ; en effet, il est difficile pour le fabricant de circuits intégrés de réaliser plusieurs couches aussi peu épaisses que 5 nm, couches qui sont nécessaires à la réalisation du puits quantique ;
- ensuite, les circuits proposés ne fonctionnent qu'à la température de 77°K ; ceci est un inconvénient rédhibitoire pour les applications grand public envisagées par exemple dans le domaine de la télévision ;
- de plus, dans une application, la multiplication de fréquence est obtenue en polarisant le dispositif autour de son pic de courant. Comme ce dernier est suivi d'une discontinuité, il apparaît une transition abrupte sur le signal de sortie, qui correspond a un spectre très riche en de multiples harmoniques. Donc si l'on désire obtenir un signal plus pur, il est indispensable de filtrer ce signal avant de pouvoir l'utiliser.
- d'une manière générale, l'existence de la discontinuité qui existe dans la caractéristique du courant de base en fonction de la tension base-émetteur, due aux niveaux d'énergie discrets, engendre des instabilités.

Selon l'invention ces inconvénients sont évités au moyen d'un dispositif tel que décrit dans le préambule, caractérisé en ce que ces moyens de polarisation incluent la connexion directe de la source du transistor à la masse, la connexion du drain du transistor à une alimentation continue fixe positive ($V_{DD}$) à travers une charge ($R_\ell$), la sortie du dispositif étant disponible au point commun du drain du transistor et de la charge, et des moyens de connexion de la grille du transistor à un signal dont la valeur moyenne est appropriée à obtenir ledit maximum du courant drain-source, et en ce que, pour obtenir un modulateur de phase, les moyens de connexion de la grille comportent un élément L-C dit T de polarisation, consistant en une inductance L disposée entre la grille et une entrée (N) pour une tension d'entrée numérique dont les niveaux logiques 0 et 1 sont respectivement symétriques par rapport à la valeur de la tension grille-source qui engendre le maximum du courant drain-source, et consistant en outre en une capacité C disposée entre la grille et une entrée ($F_0$) pour un signal alternatif à une fréquence $F_0$, résultant en un déphasage entre les signaux de sorties correspondants respectivement aux états 0 et 1 du signal numérique.

Les applications à température ambiante du phénomène de transconductance du transistor à effet de champ du type à grille isolée, cette transconductance ayant un maximum de part et d'autre duquel les pentes sont sensiblement symétriques, et la pente au-delà du maximum correspondant à une zone de transconductance négative, sont complètement inconnues de tous les documents cités.

La symétrie autour du maximum (dérivée première nulle), permet d'obtenir, pour deux valeurs symétriques de la tension grille-source de part et d'autre du maximum, une seule valeur du courant drain-source.

Il résulte de cet effet de nombreuses applications, dont les avantages principaux résident dans la simplicité de réalisation du transistor, la possibilité de travailler à température ambiante, la stabilité des signaux de sortie, et la simplicité des circuits eux-mêmes.

Dans une autre mise en oeuvre, ce dispositif est caractérisé en ce que, pour obtenir un déphaseur 0-180°, il comprend deux cicuits modulateurs de phase montés symétriquement, dont l'un reçoit, sur son entrée ($N_1$) pour un premier signal numérique, une tension correspondant au niveau 0, dont l'autre reçoit, sur son entrée ($N_2$) pour un second signal numérique, une tension correspondant au niveau 1, et les entrées ($F_0$) pour un signal alternatif des deux circuits étant couplées, les sorties des deux circuits en opposition de phase étant respectivement disponibles sur les drains des transistors de ces deux circuits.

Du fait que les transistors fonctionnent autour d'un maxiumum réel (dérivée première = 0) et non dans une région de discontinuité comme il était connu du troisième document cité, les circuit ont tous une grande stabilité. De plus, du fait que, pour deux valeur de la tension grille-source symétriques par rapport au maximum, on a une seule valeur du courant drain-source, au lieu d'avoir deux valeurs de courant de base seulement stables de part et d'autre du point résonant comme connu de ce troisième document cité, et de très nombreuses applications sont possibles aussi bien numériques qu'analogiques, en utilisant l'effet selon l'invention.

L'invention sera mieux comprise au moyen de la description suivant illustrée par les figures annexées dont :

- la figure 1 qui représente un transistor à effet de champ à grille isolée à hétérojonction favorable à la mise en oeuvre de l'invention ;
- les figures 2a à 2c qui illustrent les niveaux d'énergie dans un tel transistor en fonctionnement ;
- la figure 3 qui donne la caractéristique du courant drain-source à saturation en fonction de la tension grille-source ;

- la figure 4a qui montre un circuit non-ou exclusif décrit à titre d'exemple ;
- la figure 4b qui montre un séquencement des signaux dans le circuit non-ou exclusif selon la figure 4a, et en particulier le séquencement des tensions d'entrée $E_1$ et $E_2$, et de sortie S en fonction du temps t ;
- la figure 5a qui montre un schéma d'un multiplieur de fréquences décrit à titre d'exemple ;
- la figure 5b qui montre la courbe de la tension de sortie $V_S$ en fonction de la tension grille-source $V_E$ dans le circuit de la figure 5a ;
- la figure 5c qui montre la forme du signal de sortie obtenu avec le dispositif de la figure 5a lorsqu'un signal sinusoïdal est appliqué à l'entrée de la grille du transistor ;
- la figure 6 qui montre un modulateur de phase ;
- la figure 7 qui montre un déphaseur 0-180°.

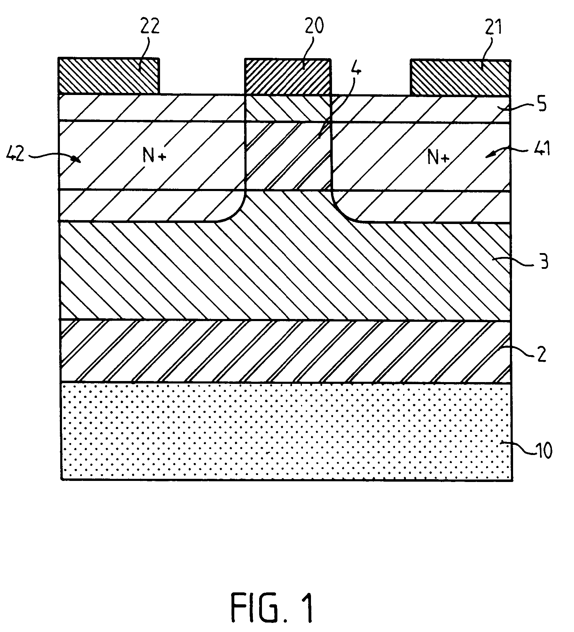

La figure 1 montre un transistor à effet de champ à grille isolée à hétérojonction de structure appropriée à la mise en oeuvre de l'invention.

Tel que représenté sur la figure 1, ce transistor comprend, réalisé sur un substrat binaire 10 une couche tampon binaire 2 puis une hétérostructure formée d'une couche binaire non-intentionnellement dopée 3, surmontée d'une couche ternaire non-intentionnellement dopée 4. La structure de ce transistor comprend aussi une couche supérieure de protection 5 en un matériau binaire non-intentionnellement dopé.

Les couches binaires seront favorablement en un composé semiconducteur du groupe III-V telles que l'arséniure de gallium (GaAs) et les couches ternaires en un composé semi-conducteur III-V d'arséniure de gallium et d'aluminium (GaAlAs).

Ce dispositif comporte aussi à sa surface supérieure un contact de grille 20, en un métal choisi favorablement parmi les métaux réfractaires tels que WN ou WSi ou bien en un semiconducteur très dopé, tel que l'arséniure de gallium fortement dopé.

Ce dispositif comporte en outre de part et d'autre de la grille 20, une électrode de source 21 et une électrode de drain 22 réalisées sur des caissons 41 et 42 fortement dopés qui délimitent les régions de source et de drain.

Un procédé de réalisation pour mettre en oeuvre un tel transistor est notamment connu de la publication intitulée "High Performance WN-gate MISFETs Fabricated From MOVPE Wafers", par M.WOLNY et alii dans "Electronics Letters, 8th October 1987, Vol.23, N° 21, pp.1127-1128".

Ce document décrit un procédé de réalisation pour obtenir un transistor comprenant d'abord un substrat semi-isolant en GaAs, couvert d'une couche tampon en GaAlAs non-intentionnellement dopée. Ce transistor comprend ensuite une hétérostructure formée d'une couche d'épaisseur environ 0,6 μm de GaAs non-intentionnellement dopée, couverte d'une couche d'épaisseur environ 40 nm de GaAlAs non-intentionnellement dopée. Cette dernière couche est couverte d'une couche peu épaisse de GaAs non-intentionnellement dopée servant de couche protectrice pour empêcher l'oxydation de la couche supérieure de l'hétérostructure. En surface de la couche protectrice est réalisé un contact de grille en un métal réfractaire WN de part et d'autre duquel des caissons de type $N^+$ délimitent les régions de source et de drain sur lesquelles sont établis des contacts ohmiques de source et drain en un alliage Au-Ge-Ni.

Ce transistor connu présente l'avantage d'être d'une réalisation simple et de performances élevées particulièrement favorables à la réalisation de la présente invention.

Les figures 2 représentent les niveaux d'énergie des bas des bandes de conduction des différents matériaux constituant le transistor, pour différentes valeurs de la tension de polarisation continue de grille $V_{GS}$.

La référence 120 montre le niveau d'énergie du métal de grille, la référence 104 celui du matériau 4 ternaire, et la référence 103 celui du matériau binaire 3 de l'hétérojonction. La valeur $\Delta E_c$ est la différence d'énergie entre les bas des bandes de conduction des matériaux 3 et 4 formant cette hétérojonction.

La figure 2a montre les niveaux d'énergie pour chacun des matériaux formant le transistor à $V_{GS} = 0$. Initialement, lorsque la polarisation de grille $V_{GS} = 0$, le niveau de Fermi est aligné avec celui du métal.

La figure 2b représente ces niveaux d'énergie lorsque la tension de polarisation de grille $V_{GS}$ est supérieure à 0. Cette figure montre que les bandes de conduction se déforment et qu'un puits de potentiel se forme au point 100. En 100, il y a accumulation d'un gaz bidimensionnel.

La figure 2c montre ces mêmes bandes lorsque la polarisation de grille $V_{GS}$ devient très supérieure à 0. Les bandes se déforment alors de telle manière que toute la tension est en fait aux bornes de la couche ternaire parce que le point 100 n'évolue plus ou très peu. On est en effet dans le gaz bidimensionnel et en-dessous du niveau de Fermi. En conséquence, l'épaisseur apparente de la couche ternaire 4 diminue et il y a apparition d'un effet tunnel qui s'ajoute à l'émission thermoionique à l'interface des deux couches 3 et 4 formant l'hétérojonction.

En effet, dès que le gaz bidimensionnel existe, lorsqu'une tension drain-source est appliquée, des porteurs accélérés deviennent énergétiques, peuvent franchir la barrière d'énergie $\Delta E_c$ et sont collectés par la grille. Ainsi quand on polarise fortement la grille par une tension $V_G$ en direct, on observe une diminution du courant de drain, car lorsque l'on augmente $V_{DS}$, la barrière apparente pour les électrons s'affaiblie et la probabilité pour que ces électrons franchissent la barrière augmente fortement. Tous les électrons qui s'échappent du gaz bidimensionnel ne participent donc plus au courant de drain $I_{DS}$ et ce dernier diminue.On obtient alors une caractéristique du courant drain-source à saturation $I_{DSS}$ en fonction de la tension grille-source $V_{GS}$ tel que représenté sur la figure 3. La zone ou le courant diminue pour une tension $V_{GS}$ supérieure à une tension $V_{GS0}$ correspond à un régime de transconductance négative.

Le transistor décrit précédemment et illustré par la figure 1, référencé $T_1$ peut être polarisé dans des conditions favorables à l'obtention du maximum du courant drain-source qui apparaît précédant le régime de transconductance négative.

On décrit ci-après quatre exemples de mise en oeuvre de moyens de polarisation pour qu'un transistor à effet de champ à grille isolée, montre, dans le cas où la grille est polarisée en continu à un niveau élevé, une caractéristique de courant drain-source en fonction de la tension grille-source avec une zone de transconductance négative au-delà d'un maximum, de part et d'autre duquel. les pentes de cette caractéristique sont sensiblement symétriques. Lorsque le transistor est muni de ces moyens de polarisation, son régime de fonctionnement se situe dans la région de la caractéristique située autour du maximum, en sorte que deux valeurs de la tension grille-source symétriques par rapport à ce maximum correspondent sensiblement à une même valeur du courant drain-source.

D'une manière générale, ces moyens de polarisation incluent la connexion directe de la source 21 du transistor à effet de champ à grille isolée $T_1$ à la masse, et la connexion de son drain 22 à une alimentation continue fixe positive $V_{DD}$, à travers une charge $R_\ell$, la sortie S du dispositif étant disponible au point commun du drain 22 du transistor $T_1$ de la charge $R_\ell$, et des moyens de connexion de la grille 20 du transistor $T_1$ à un signal dont la valeur moyenne est appropriée à obtenir ledit maximum du courant drain-source.

On notera que les exemples T concernant un circuit NON-OU-EXCLUSIF, et II concernant un circuit DOUBLEUR DE FREQUENCE ne sont pas revendiqués.

## Exemple I

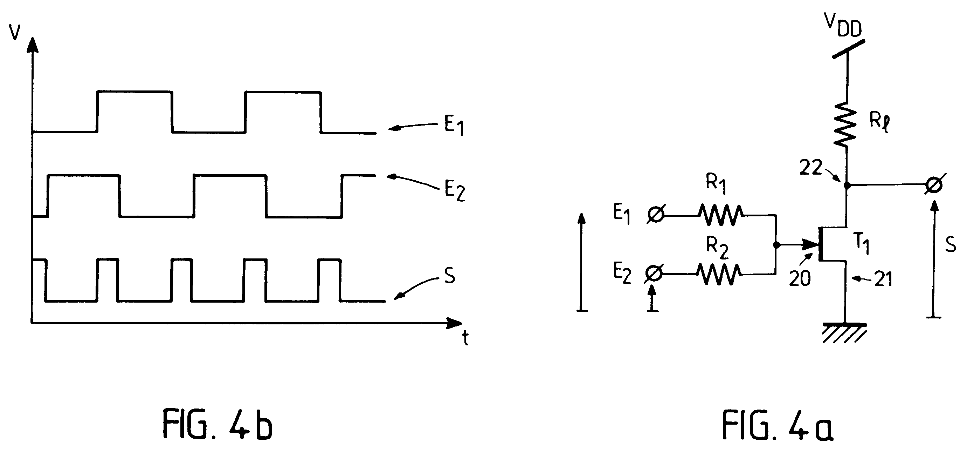

Dans cet exemple, illustré par les figures 4a et 4b, on décrit des moyens de connexion appliqués sur la grille 20 pour obtenir un circuit non-ou-exclusif, ces moyens de connexion étant appliqués en coopération avec les moyens de polarisation cités plus haut.

Comme il est montré sur le schéma de la figure 4a, le circuit de polarisation pour obtenir un étage OU-EXCLUSIF complémentaire à partir d'un transistor à effet de champ $T_1$ à grille isolée, comprend des moyens pour que, pour certaines valeurs de la tension appliquée sur la grille, on se trouve dans la région de la caractéristique $I_{DS}$ en fonction de $V_{GS}$ située autour du maximum C de la courbe de la figure 3.

A cet effet, conformément à ce qui a été dit, tel que montré sur la figure 4a, la résistance $R_\ell$ est disposée entre le drain 22 du transistor $T_1$ et la borne d'alimentation continue positive $V_{DD}$, la source 21 du transistor $T_1$ étant reliée directement à la masse.

Le signal d'entrée est appliqué sur la grille 20 du transistor $T_1$, et la sortie est disponible sur son drain 22, au point commun avec la résistance $R_\ell$.

Dans ces conditions, si l'on applique au transistor $T_1$ une tension grille-source $V_{GS}$ d'une valeur croissante dans un domaine où elle est suffisamment élevée pour produire l'effet illustré par la figure 2c, on constate, comme il est montré sur la figure 3 que le courant drain-source à saturation $I_{DSS}$ commence par augmenter, passe par un maximum en C puis diminue. La valeur de la tension grille-source qui produit le maximum $I_{DS0}$ en C du courant drain-source est notée ci-après $V_{GS0}$.

Tel que représenté sur la figure 4a, le circuit non-ou-exclusif selon l'invention comprend deux entrées $E_1$ et $E_2$ reliées chacune à la grille 20 à travers des résistances de valeurs égales $R_1$ et $R_2$.

La figure 4b montre la forme des signaux numériques qui peuvent être appliqués d'une part sur l'entrée $E_1$ et d'autre part sur l'entrée $E_2$ ainsi que la forme des signaux de sortie S que l'on peut prélever entre le drain et la masse.

Il est essentiel à la mise en oeuvre de l'invention, que le niveau des tensions d'entrée $E_1$ et $E_2$ soit tel que le niveau haut (1) et le niveau bas (0) admettent pour valeur moyenne en tension, la valeur égale à la valeur $V_{GS0}$ qui provoque le maximum $I_{DS0}$ en C de la caractéristique $I_{DS}$ en fonction de $V_{GS}$ représenté sur la figure 3.

Dans ces conditions, tel que montré sur la figure 4b, lorsque les entrées $E_1 = E_2$ et sont toutes deux au niveau bas (0), ce niveau bas se retrouve sur la grille du transistor $T_1$. On obtient alors d'après la courbe de la figure 3 un certain courant drain-source soit $I_{DS1}$ (point A de la courbe de la figure 3).

D'autre part, lorsque les entrées $E_1 = E_2$ sont toutes deux au niveau haut (1), ce niveau haut se retrouve sur la grille du transistor $T_1$. Par symétrie autour du maximum $V_{GS0}$ on obtient le même courant drain-source

$I_{DS1}$ que lorsque les entrées sont toutes les deux au niveau bas. Ce courant $I_{DS1}$ est inférieur au maximum du courant drain-source de la courbe de la figure 3 (point B de la courbe de la figure 3).

Par contre, lorsque l'entrée $E_1$ est dans un état différent de l'entrée $E_2$, l'une étant à l'état 0, et l'autre à l'état 1, on trouve sur la grille 20 du transistor $T_1$ une tension égale à $(E_1 + E_2)/2$ qui correspond à la valeur $V_{GS0}$, c'est-à-dire au maximum $I_{DS0}$ du courant drain-source (point C de la courbe de la figure 3).

En résumé, en choisissant des niveaux 0 et 1 des tensions d'entrée $E_1$ et $E_2$ symétriques par rapport à la valeur $V_{GS0}$ qui provoque le maximum de la courbe $I_{DS}$ en fonction de $V_{GS}$ de la figure 3, lorsque :

$$\left. \begin{array}{l} E_1 = E_2 = 0 \\ ou \\ E_1 = E_2 = 1 \end{array} \right\} \quad I_{DS} = I_{DS1} < \text{au maximum } I_{DS0}$$

et lorsque :

$$\left. \begin{array}{ll} E_1 = 0 & E_2 = 1 \\ ou & \\ E_1 = 1 & E_2 = 0 \end{array} \right\} \quad I_{DS} = I_{DS0} \text{ maximum.}$$

La tension de sortie $V_{DS}$ se calcule à partir de la tension d'alimentation continue positive $V_{DD}$

$$V_{DS} = V_{DD} - R_\ell \times I_{DS}$$

donc, lorsque $I_{DS}$ est au maximum, $V_{DS}$ est à l'état bas (0) et lorsque $I_{DS}$ est inférieur au maximum, $V_{DS}$ est à l'état haut (1). En appelant S la sortie prélevée entre le drain et la masse on obtient le tableau logique suivant :

**TABLEAU I**

| $E_1$ | $E_2$ | S |
|-------|-------|---|
| 0 | 0 | 1 |
| 1 | 1 | 1 |
| 0 | 1 | 0 |
| 1 | 0 | 0 |

On a ainsi constitué un détecteur d'égalité, ou plus exactement une porte OU-EXCLUSIF complémentaire.

Cette fonction est réalisée ici avec un seul transistor alors qu'on la trouve habituellement dans l'état de la technique réalisée avec environ 8 transistors.

Dans une réalisation préférentielle où le transistor $T_1$ est un transistor du type décrit dans la dernière publication citée et représenté schématiquement sur la figure 1,
- la tension $V_{DD} = 6$ V
- la résistance $R_\ell = 3,9$ kΩ
- les résistances $R_1 = R_2 = 50$ Ω
- la largeur de grille du transistor $T_1$, $W = 10 \mu m$
- la valeur de la tension $V_{GS0} = 2,5$ V
- le niveau 0 pour les entrées $E_1$ et $E_2$ est 2 V
- le niveau 1 pour les entrées $E_1$ et $E_2$ est 3 V
- le niveau 1 de la tension de sortie est 3 V
- le niveau 0 de la tension de sortie est 2 V
- la consommation du circuit est 5 mW environ.

## Exemple II

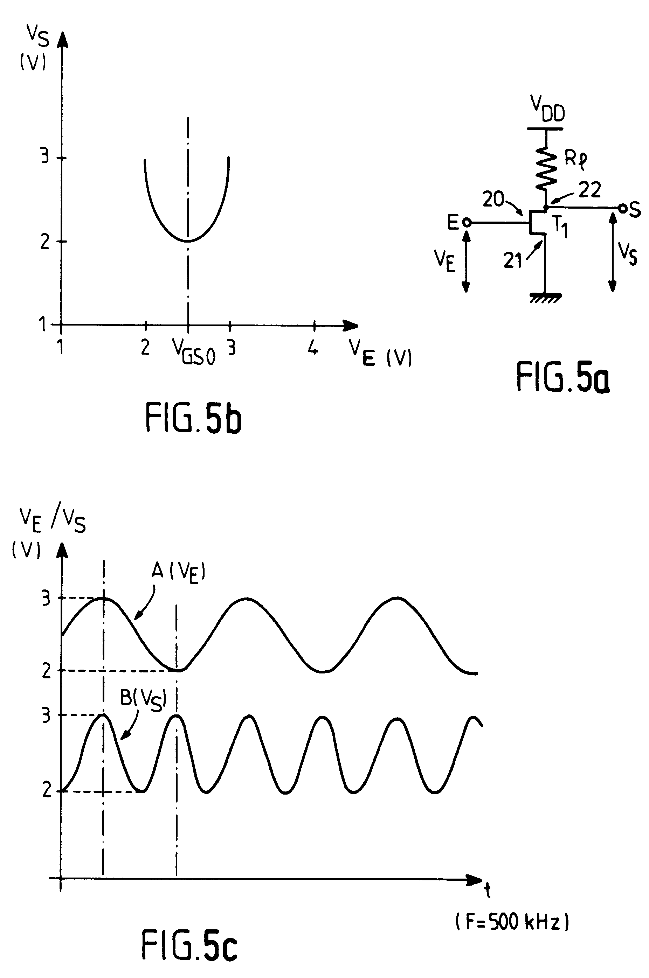

Dans cet exemple illustré par les figures 5a à 5c, on décrit des moyens de connexion appliqués sur la grille pour obtenir un circuit multiplieur de fréquence par deux, ces moyens étant appliqués en coopération avec les moyens de polarisation déjà cités.

L'entrée de l'étage se fait directement sur la grille 20 du transistor $T_1$, et la sortie sur son drain 22, au point commun avec la résistance $R_\ell$.

Comme précédemment, si l'on applique au transistor $T_1$ une tension grille-source $V_{GS}$ d'une valeur croissante dans un domaine où elle est suffisamment élevée pour produire l'effet illustré par la figure 2c, on constate, comme il est montré sur la figure 3, que le courant drain-source à saturation $I_{DSS}$ commence par augmenter, passe par un maximum au point C puis diminue. La valeur de la tension grille-source qui produit le maximum $I_{DS0}$ au point C du courant drain-source est $V_{GS0}$.

La figure 5b représente en statique les variations de la tension de sortie $V_S$ prélevée entre le drain 22 du transistor $T_1$ et la masse, en fonction de la tension $V_E$ appliquée entre la grille 20 du transistor $T_1$ et la masse pour le circuit représenté sur le schéma de la figure 5a. La figure 5b montre que, lorsque la tension d'entrée $V_E$ atteint la valeur $V_{GS0}$, la tension de sortie $V_S$ passe par un minimum. En effet, comme on l'a dit, la tension de sortie s'exprime en fonction du courant $I_{DS}$ par la relation suivante :

$$V_S = V_{DD} - R_\ell . I_{DSS}$$

La tension d'alimentation continue positive $V_{DD}$ étant fixée ainsi que la valeur de la résistance de charge $R_\ell$, lorsque pour $V_{GS0}$, le courant $I_{DS}$ passe par un maximum (voir la figure 3), alors la tension de sortie $V_S$ passe par un minimum (voir la figure 5b).

Dans ces conditions, lorsque l'on applique à l'entrée du circuit conforme au schéma de la figure 5b une tension $V_E$ analogique par exemple un signal hyperfréquence à une fréquence F, dont la forme est représentée par la courbe A de la figure 5c, au cours d'une demi-période où la tension $V_E$ augmente, la valeur de la tension de sortie $V_S$ diminue puis augmente. Au cours de la seconde demi-période la tension $V_E$ diminue en repassant par les mêmes valeurs qu'au cours de la première demi-période, et il en est de même de la tension de sortie $V_S$ qui diminue donc à nouveau puis réaugmente.

Si la composante continue du signal d'entrée $V_E$ est bien centrée sur la tension $V_{GS0}$ qui donne un maximum en C de la caractéristique du courant drain-source à saturation $I_{DSS}$ en fonction de la tension grille-source $V_{GS}$, alors le circuit représenté sur le schéma de la figure 5a constitue un doubleur de fréquence parfait.

Ce circuit présente de nombreux avantages. Il est notamment réalisé au moyen d'un seul composant actif. Ce composant actif fonctionne à température ambiante. Le signal de sortie à la fréquence 2F, c'est-à-dire 2 fois la fréquence F du signal d'entrée est pur. Il ne nécessite pas de filtrage. Il utilise le phénomène de transconductance négative qui apparaît pour le transistor décrit plus haut aux fortes polarisations de grille.

Dans une réalisation préférentielle où le transistor $T_1$ est un transistor du type décrit dans la dernière publication citée et représenté schématiquement sur la figure 1,
- la tension $V_{DD} = 6$ V
- la résistance $R_\ell = 3,9$ kΩ
- la largeur de grille du transistor $T_1$, W = 10μm
- la valeur de la tension $V_{GS0} = 2,5$ V
- l'amplitude de la composante continue du signal d'entrée $V_E$ est située entre 2 V et 3 V, de même que celle du signal de sortie $V_S$
- la fréquence F expérimentée était F = 500 KHz.

## Exemple III

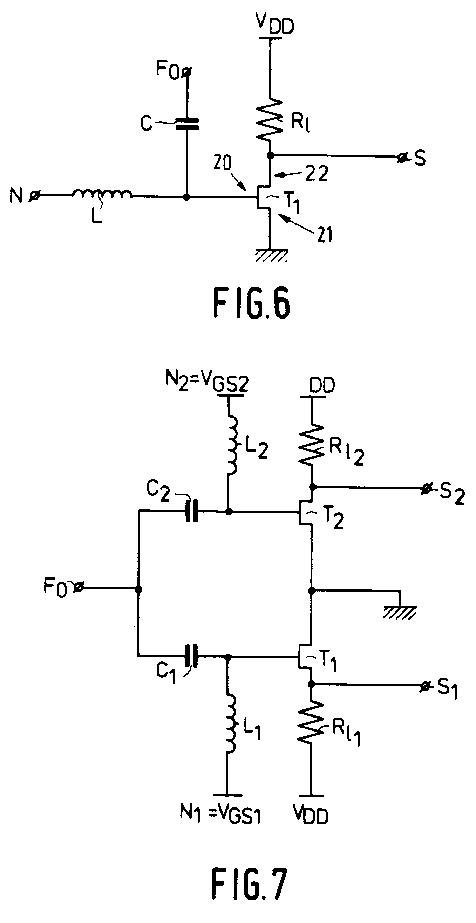

Dans cet exemple illustré par les figures 6, on décrit des moyens appliqués sur la grille pour obtenir un modulateur de phase, ces moyens étant appliqués en coopération avec les moyens de polarisation déjà cités.

La figure 3 montre que, pour une valeur $V_{GS} = V_{GS1}$ (point A de la figure 3), la transconductance est positive et égale à $gm_0$. D'autre part, pour une valeur $V_{GS} = V_{GS2}$, (point B de la figure 3) la transconductance a la même valeur absolue $gm_0$ qu'au point A, mais est négative.

La valeur de la tension de sortie $V_S$ est donnée par :

$$V_S = V_{DD} - R_\ell I_{DS}$$

En petit signal et à saturation, on écrira :

$$v_s = R_\ell . i_{ds} = - R_\ell . gm . v_e$$

où $v_s$ est l'amplitude du petit signal prélevé à la sortie, et $v_e$ est l'amplitude du petit signal appliqué à l'entrée. Dans le premier cas où :

$$V_{GS} = V_{GS1} \qquad v_s/v_e = - R_\ell . gm_0 \quad (1)$$

et dans le cas où

$$V_{GS} = V_{GS2} \qquad v_s/v_e = R_\ell . gm_0 \quad (2)$$

Si le signal d'entrée $v_e$ est de la forme :

$v_e = a$ Sin $\omega t$ où $\underline{a}$ est une constante,

les expressions (1) et (2) entraînent les expressions

(1') et (2') suivantes, où $\varphi$ est un déphasage :

$$v_s = a.R_\ell.gm_0.Sin(\omega t + \varphi) \text{ avec } \varphi = 180° \quad (1')$$
$$v_s = a.R_\ell.gm_0.Sin(\omega t) \quad (2')$$

Donc en $V_{GS1}$ au point (A), un petit signal $v_e$ appliqué à l'entrée sur la porteuse $V_{GS}$, est amplifié de $R_\ell.gm_0$, et en $V_{GS}$ au point (B), un petit signal $v_e$ appliqué à l'entrée sur la porteuse $V_{GS}$ est amplifié de $-R_\ell.gm_0$, c'est-à-dire amplifié de $R_\ell.gm_0$ et déphasé de 180°.

Cette propriété du circuit de la figure 5a est appliqué à la réalisation d'un modulateur de phase montré sur la figure 6. Il s'agit ici de moduler un signal de fréquence $F_0$ par un signal numérique N, en associant au signal de sortie S modulé une phase $\varphi_1$ lorsque le signal numérique N = 0, et une phase $\varphi_2$ lorsque le signal numérique N = 1.

Le schéma de la figure 6 montre que ce but est atteint en appliquant sur la grille 20 du transistor $T_1$, les signaux numérique N et analogique de fréquence $F_0$ au moyen d'un élément dit "T de polarisation".

Le signal numérique N est appliqué à une extrémité d'une inductance L, dont l'autre extrémité est reliée à la grille 20. le signal analogique de fréquence $F_0$ est appliqué à une extrémité d'une capacité C dont l'autre extrémité est reliée à la grille 20.

La modulation en phase du signal à la fréquence $F_0$ est obtenue lorsque les états du signal numérique correspondent à :

N = 0 pour $V_{GS} = V_{GS1}$

N = 1 pour $V_{GS} = V_{GS2}$

Dans une réalisation préférentielle, ce circuit est réalisé, pour moduler un signal à la fréquence

$F_0$ = 2 GHz

avec les éléments suivants :

L = 5 nH

C = 12 pF $\qquad V_{GS1} = 1,5$ V

$R_\ell$ = 3,6 KΩ $\qquad V_{GS2} = 2,5$ V

W = 10 μm

$V_{DD}$ = 5V

## Exemple IV

Cet exemple, illustré par la figure 7, s'appuie sur les propriétés du circuit de la figure 5a explicitées dans l'exemple III, et propose d'appliquer ces propriétés à la réalisation d'un déphaseur 0-180°.

Une telle fonction est obtenue au moyen du circuit de la figure 7. Le circuit de la figure 7 comprend deux circuits conformes au circuit de la figure 6.

Chacun des circuits reçoit sur l'entrée N à l'extrémité de l'inductance L une tension $V_{GS}$ de polarisation grille-source différente. L'un recevra sur son entrée $N_1$, $V_{GS} = V_{GS1}$ fixe. L'autre recevra sur son entrée $N_2$, $V_{GS} = V_{GS2}$ fixe. Les deux circuits seront reliés par l'extrémité de la capacité C qui reçoit le petit signal à la fréquence $F_0$.

A chacune des tensions de polarisation $V_{GS1}$ et $V_{GS2}$ sont associées respectivement les transconductances $gm_0$ de même valeur absolue et de signes différents.

Les sorties $S_1$ et $S_2$ disponibles respectivement sur les drains des transistors $T_1$ et $_2$ des deux circuits associés seront déphasés l'une vis-à-vis de l'autre de 180°.

Dans une réalisation préférentielle, pour un signal d'entrée à la fréquence

$F_0$ = 2 GHz

On utilisera les élements suivants :

$L_1 = L_2 = 5$ nH

$C_1 = C_2 = 12$ pF

$R_{\ell 1} = R_{\ell 2} = 3,9$ KΩ

$W_1 = W_2 = 10$ μm

$V_{DD}$ = 6V

$N_1 = V_{GS1} = 1,5$ V $\qquad \varphi_1 = 0°$ pour $S_1$

$N_2 = V_{GS2} = 2,5$ V $\qquad \varphi_2 = 180°$ pour $S_2$

Les transistors décrits dans les publications citées comme pouvant convenir à mettre en oeuvre l'invention ne sont pas les seuls à montrer un effet de transconductance négative.

En fait, tout transistor qui est à la fois du type à effet de champ (unipolaire) et à grille isolée, peut être utilisé pour réaliser des circuits selon les exemples I à IV. D'une manière générale, lorsque l'on applique sur la grille de l'un de ces transistors une tension $V_{GS}$ élevée, on obtient une caractéristique $I_{DS}$ en fonction de $V_{GS}$ qui montre un maximum (dérivée première égale à zéro) de part et d'autre duquel les pentes de la courbe sont sensiblement symétriques en sorte qu'à deux valeurs de $V_{GS}$ symétriques par rapport au maximum correspond une seule valeur du courant $I_{DS}$. Et l'on peut relier la source à la masse et le drain à une tension d'alimentation positive $V_{DD}$ pour que le circuit ait un régime de fonctionnement dans la région située autour du maximum.

A titre d'exemple de transistors à effet de champ pouvant être utilisés, on cite entre autres :

a) les MOSFETs (de l'anglais Metal-Oxyde-Semiconductor-Field-Effect-Transistor). Dans ce type de transistors, généralement réalisés sur silicium, la grille qui est métallique, est isolée de la couche active par une couche d'oxyde. La conductance négative de drain peut être obtenue du fait que des électrons quittent la couche active, traversent la couche d'oxyde par effet tunnel et sont captés par la grille lorsque cette dernière est polarisée à un niveau $V_1$ convenable.

b) Les HIGFETs (de l'anglais Heterostructure Insulated Gate Field Effect Transistor). Dans ce type de transistors, généralement réalisés en matériaux III-V, la grille est isolée de la couche active par une couche formant une hétérostructure avec la couche active. Dans cette catégorie, on trouve plusieurs sous-groupes de transistors qui peuvent permettre de mettre en oeuvre l'invention.

- les transistors dont le substrat est semi-isolant : dans ce cas l'effet de conductance négative de drain se produit du fait que les électrons du gaz bidimensionnel (voir plus haut) sont captés par la grille ;
- les transistors dont le substrat est conducteur par exemple formé d'un matériau semiconducteur dopé (par exemple dopé N$^+$). Dans ce cas la conductance négative de drain est obtenue par l'émission d'électrons chauds (en anglais Hot Electrons) vers le substrat conducteur et non vers la grille.

Dans le groupe des HIGFETs, la grille des transistors à effet de champ peut être réalisée de deux manières différentes. La grille peut être métallique pour les MISFETs (de l'anglais : Metal-Insulator-Semiconductor-Field-Effect Transistor), ou bien la grille peut être elle-même en un matériau semiconducteur pour les SISFETs (Semiconductor-Insulator-Semiconductor-Field-Effect-transistor). Pour les électrons chauds, le matériau formant la grille est en fait indifférent et l'effet n'est pas changé.

Dans tout l'exposé précédent, on notera que l'on n'a pas cité comme aptes à une mise en oeuvre de l'invention les transistors à puits quantiques connus comme on l'a dit précédemment de la demande EP 0 225 698. Les défauts décrits précédemment et inhérents à ce type de transistor proviennent essentiellement de l'existence de la discontinuité qui ne permet pas d'obtenir un maximum définissant deux parties de courbes symétriques. En conséquence on peut seulement obtenir avec les transistors à puits quantiques deux valeurs de courant de base stables (mais non identiques) de part et d'autre du point résonant défini par la tension base-émetteur. Les applications sont donc non seulement limitées par la complexité du dispositif (couches ultra-minces etc..) par sa température d'opération (77°K) mais aussi par le manque de symétrie de la caractéristique.

## Revendications

1. Dispositif semiconducteur intégré, incluant un transistor à effet de champ, d'un type dit à grille isolée, ce transistor étant muni de moyens de polarisation pour obtenir que sa grille soit polarisée en continu à un niveau élevé, de manière à ce que le régime de fonctionnement de ce transistor se situe dans une région où sa caractéristique de courant drain-source en fonction de la tension grille-source montre un maximum de part et d'autre duquel les pentes de la caractéristique sont sensiblement symétriques, en sorte qu'à deux valeurs de la tension grille-source symétrique par rapport à ce maximum correspond sensiblement une même valeur du courant drain-source, caractérisé en ce que ces moyens de polarisation incluent la connexion directe de la source du transistor à la masse, la connexion du drain du transistor à une alimentation continue fixe positive ($V_{DD}$) à travers une charge ($R_\ell$), la sortie du dispositif étant disponible au point commun du drain du transistor et de la charge, et des moyens de connexion de la grille du transistor à un signal dont la valeur moyenne est appropriée à obtenir ledit maximum du courant drain-source, et en ce que, pour obtenir un modulateur de phase, les moyens de connexion de la grille comportent un élément L-C dit T de polarisation, consistant en une inductance L disposée entre la grille et une entrée (N) pour une tension d'entrée numérique dont les niveaux logiques 0 et 1 sont respectivement symétriques par rapport à la valeur de la tension grille-source qui engendre le maximum du courant drain-source, et consistant en outre en une capacité C disposée entre la grille et une entrée ($F_0$) pour un signal alternatif à une fréquence $F_0$, résultant en un déphasage entre les signaux de sortie correspondant respectivement aux états 0 et 1 du signal numérique.

2. Dispositif selon la revendication 1, caractérisé en ce que pour obtenir un déphaseur 0-180°, ce dispositif comprend deux circuits modulateurs de phase montés symétriquement, dont l'un reçoit, sur son entrée ($N_1$) pour un premier signal numérique, une tension correspondant au niveau 0, dont l'autre reçoit, sur son entrée ($N_2$) pour un second signal numérique, une tension correspondant au niveau 1, et les entrées ($F_0$) pour un signal alternatif des deux circuits étant couplées, les sorties des deux circuits en opposition de phase étant respectivement disponibles sur les drains des transistors de ces deux circuits.

3. Dispositif selon l'une des revendications 1 ou 2, caractérisé en ce que le (ou les) transistor(s) à effet de champ à grille isolée est (sont) du type à grille isolée du canal par une couche d'oxyde.

4. Dispositif selon l'une des revendications 1 ou 2, caractérisé en ce que la couche d'isolation de grille constitue une hétérostructure avec la couche formant le canal du transistor à effet de champ à grille isolée.

5. Dispositif selon la revendication 4, caractérisé en ce que la grille du transistor à effet de champ à grille isolée est métallique.

6. Dispositif selon la revendication 4, caractérisé en ce que la grille du transistor à effet de champ à grille isolée est en un matériau semiconducteur.

7. Dispositif selon l'une des revendications 4 à 6, caractérisé en ce que le substrat du transistor à effet de champ à grille isolée est semi-isolant.

8. Dispositif selon l'une des revendications 4 à 6, caractérisé en ce que le substrat du transistor à effet de champ à grille isolée est conducteur, par exemple formé d'un matériau semiconducteur dopé.


## Patentansprüche

1. Integrierte Halbleitervorrichtung mit einem Feldeffekttransistor eines Typs mit isoliertem Gate, wobei dieser Transistor mit Mitteln zum Vorspannen versehen ist, um sein Gate auf einem erhöhten Pegel vorzuspannen, so daß der Betriebsbereich dieses Transistors in einem Bereich liegt, in dem seine Drain-Source-Strom-Kennlinie in Abhängigkeit von der Gate-Source-Spannung ein Maximum erreicht, beiderseits dessen die Steigungen der Kennlinie praktisch symmetrisch sind, so daß praktisch zwei zu diesem Maximum symmetrischen Werten der Gate-Source-Spannung ein einziger Wert des Drain-Source-Stroms entspricht, dadurch gekennzeichnet, daß diese Vorspannungsmittel den direkten Anschluß der Transistor-Source an Masse, den Anschluß des Transistor-Drains an eine positive feste Versorgungsgleichspannung ($V_{DD}$) über eine Last ($R_\ell$), wobei das Ausgangssignal der Vorrichtung am Verbindungspunkt des Transistor-Drains und der Last ansteht, sowie Mittel zum Anschluß des Transistor-Gates an ein Signal, dessen Mittelwert so angepaßt ist, daß man das Maximum des Drain-Source-Stroms erreicht, umfassen, und daß die Gate-Anschlußmittel ein mit T bezeichnetes Vorspannungs-L-C-Glied umfassen, das aus einer zwischen dem Gate und einem Eingang (N) für eine digitale Eingangsspannung angeordneten Induktivität L mit Logikpegeln 0 und 1, die symmetrisch zum Wert der Gate-Source-Spannung sind, die das Maximum des Drain-Source-Stroms erzeugt, und außerdem aus einer Kapazität C besteht, die zwischen dem Gate und einem Eingang ($F_o$) für ein wechselndes Signal mit einer Frequenz $F_o$ angeordnet ist, was zu einer Phasenverschiebung zwischen den Ausgangssignalen, die den Zuständen 0 bzw. 1 des digitalen Signals entsprechen, führt.

2. Vorrichtung nach Anspruch 1, dadurch gekennzeichnet, daß die Vorrichtung zwei symmetrisch angeordnete Phasenmodulationsschaltungen umfaßt, um eine Schaltung zur Phasenverschiebung um 0-180° zu erhalten, von denen bei der einen am Eingang $N_1$ für ein erstes digitales Signal eine logisch 0 entsprechende Spannung angelegt wird, bei der anderen am Eingang $N_2$ für ein zweites digitales Signal eine logisch 1 entsprechende Spannung angelegt wird und die Eingänge $F_0$ für ein wechselndes Signal zweier Schaltungen gekoppelt sind, wobei die Ausgangssignale zweier Schaltungen in Gegenphase jeweils an den Drains der Transistoren dieser beiden Schaltungen anstehen.

3. Vorrichtung nach Anspruch 1 oder 2, dadurch gekennzeichnet, daß der (oder die) Feldeffekttransistor(en) mit isoliertem Gate als Transistor mit vom Kanal durch eine Oxidschicht getrenntem Gate ausgeführt ist (sind).

4.  Vorrichtung nach Anspruch 1 oder 2, dadurch gekennzeichnet, daß die Gate-Isolationsschicht eine Heterostruktur mit der Schicht, die den Kanal des Feldeffekttransistors mit isoliertem Gate bildet, darstellt.

5.  Vorrichtung nach Anspruch 4, dadurch gekennzeichnet, daß das Gate des Feldeffekttransistors mit isoliertem Gate aus Metall besteht.

6.  Vorrichtung nach Anspruch 4, dadurch gekennzeichnet, daß das Gate des Feldeffekttransistors mit isoliertem Gate aus einem Halbleitermaterial besteht.

7.  Vorrichtung nach Anspruch 4 bis 6, dadurch gekennzeichnet, daß das Substrat des Feldeffekttransistors mit isoliertem Gate halbleitend ist.

8.  Vorrichtung nach Anspruch 4 bis 6, dadurch gekennzeichnet, daß das Substrat des Feldeffekttransistors mit isoliertem Gate leitfähig ist und beispielsweise aus einem dotierten Halbleitermaterial hergestellt ist.


## Claims

1.  An integrated semiconductor device, comprising a so-called insulated-gate field-effect transistor which is provided with biasing means to ensure that its gate is continuously biased to a high level so that the operating regime of this transistor is situated in a zone in which its drain-source current characteristic as a function of the gate-source voltage exhibits a maximum to both sides of which the slopes of the characteristic are substantially symmetrical so that substantially the same value of the drain-source current corresponds to two values of the gate-source voltage which are symmetrical relative to this maximum, characterized in that said biasing means include the direct connection of the source of the transistor to ground, the connection of the drain of the transistor to a fixed, positive d.c. supply ($V_{DD}$) via a load ($R_1$), the output signal of the device being available on the common node of the drain of the transistor and the load, and means for connecting the gate of the transistor to a signal whose mean value is suitable to obtain said maximum of the drain-source current, and in that, in order to obtain a phase modulator, the gate connection means comprise an L-C element which is referred to as a "T biasing element" and which includes an inductance L arranged between the gate and an input (N) for a digital input voltage whose logic levels 0 and 1 are symmetrical relative to the value of the gate-source voltage generating the maximum of the drain-source current, and also includes a capacitance C arranged between the gate and an input ($F_0$) for an alternating signal having a frequency $F_0$ and produced by a phase shift between the output signals corresponding to the states 0 and 1, respectively, of the digital signal.

2.  A device as claimed in Claim 1, characterized in that in order to realize a 0-180° phase shifter, the device comprises two symmetrically connected phase modulator circuits, one of which receives a voltage corresponding to the level 0 on its input ($N_1$) for a first digital signal, the other circuit receiving a voltage corresponding to the level 1 on its input ($N_2$) for a second digital signal, the inputs ($F_0$) for an alternating signal of the two circuits being coupled, the output signals of the two circuits being available in phase opposition on the drains of the transistors of these two circuits.

3.  A device as claimed in any one of the Claims 1 or 2, characterized in that the insulated-gate field-effect transistor (transistors) is (are) of the type whose gate is insulated from the channel by an oxide layer.

4.  A device as claimed in any one of the Claims 1 or 2, characterized in that the insulating layer of the gate constitutes a heterostructure in conjunction with the layer forming the channel of the insulated-gate field-effect transistor.

5.  A device as claimed in Claim 4, characterized in that the gate of the insulated-gate field-effect transistor is metallic.

6.  A device as claimed in Claim 4, characterized in that the gate of the insulated-gate field-effect transistor is made of a semiconductor material.

7.  A device as claimed in any one of the Claims 4 to 6, characterized in that the substrate of the insulated-gate field-effect transistor is semi-insulating.

8. A device as claimed in any one of the Claims 4 to 6, characterized in that the substrate of the insulated-gate field-effect transistor is conductive and consists of, for example a doped semiconductor material.

22    20    21

4

42    N+    N+    41

5

3

2

10

FIG. 1

FIG. 2a

FIG. 2b

FIG. 2c

FIG. 3

14

FIG. 4b

FIG. 4a

EP 0 380 168 B1

$V_S$
(V)

3

2

1

1    2    $V_{GS0}$ 3    4    $V_E$ (V)

FIG.5b

$V_{DD}$

$R\ell$

20    22

E    $T_1$    S

$V_E$    21    $V_S$

FIG.5a

$V_E / V_S$
(V)

$A (V_E)$

3

2

$B (V_S)$

3

2

t

(F=500 kHz)

FIG.5c

FIG.6

FIG.7